# EUROPEAN PATENT APPLICATION

(11) **EP 1 148 151 A2**
(43) Date of publication of application: **24.10.2001**
(21) Application number: 01201066.6
(22) Date of filing: 22.03.2001
(51) Int. Cl.: C23C 16/46, C23C 16/458

(54) **Ceramic heater device and film forming device using the same**

(30) Priority: 18.04.2000 JP 2000116329
(71) Applicant: NHK SPRING CO.LTD., Yokohama-shi, Kanagawa-ken (JP); ASM JAPAN K.K., Tokyo 206 (JP)
(72) Inventor: Hanamachi, Toshihiko, c/o NHK Spring Co., Ltd., Yokohama-shi, Kanagawa (JP); Tachikawa, Toshihiro, c/o NHK Spring Co., Ltd., Yokohama-shi, Kanagawa (JP); Fukuda, Hideaki, Tama-shi, Tokyo (JP)
(74) Representative: Schmitz, Jean-Marie

(57) **Abstract**

A ceramic cover plate is placed on the surface of a heater typically consisting of a ceramic heater used in a CVD device so as to cover the entire heating surface of the heater, and a silicon wafer 2 is placed on a recessed supporting surface 2a defined by the surface of the cover plate 2. The surface of the ceramic heater is therefore protected by the cover made of a ceramic plate, and the surface of the ceramic heater is prevented from being directly exposed to the gas such as the cleaning gas. Because the corrosion caused by the cleaning gas is limited to the cover, the ceramic heater can be renewed simply by replacing the cover. This substantially reduces the cost for the maintenance work.

## Description

### TECHNICAL FIELD

The present invention relates to a heater device for heating various forms of works, and in particular to a ceramic heater device suitable for heating a silicon wafer in a semiconductor device fabrication system. The present invention also relates to a film forming device using such a ceramic heater.

### BACKGROUND OF THE INVENTION

A film forming device is typically based on vacuum deposition, sputtering and CVD, and is widely used for various purposes. In particular, the process of forming thin films on a silicon or other semiconductor wafer or glass substrate by CVD is an important field in the technology for fabricating semiconductor devices such as CPU and memory devices, and LCD devices. According to a typical CVD process, various material gases are energized in a process chamber under a vacuum condition by using radio frequency power and/or thermal energy to deposit various functional thin films on the surface of the semiconductor substrate.

In recent years, with the progress in the development of semiconductor devices, there is a growing demand for the reduction in the contamination of semiconductor substrates with particulate and other forms of impurities, and the metallic contamination which may be produced from the metallic susceptors and heaters in single-piece plasma CVD devices (for processing a single semiconductor wafer at a time) has come to be considered as a major source of such problems. Also, the low pressure thermal CVD batch process (for processing tens of semiconductor wafers at a time) which heats the semiconductor wafers to a temperature above 700 °C for a prolonged period of time has been known to place an undesired thermal load on the semiconductor wafers. The thermal load may cause the electric properties of the semiconductor wafers to change to such an extent that the semiconductor wafers may fail to function as designed. To eliminate such a problem, it has been proposed to use a single-piece plasma CVD device which uses a ceramic heater for directly supporting a semiconductor wafer.

The ceramic heater is made of such materials as alumina ceramic (Al₂O₃) and aluminum nitride (A1N), and can reduce the contamination of the semiconductor wafer with particulate and other forms of impurities. Also, attempts have been made to reduce the thermal load on the semiconductor wafer by using a single-piece CVD device incorporated with a ceramic heater, instead of a low pressure thermal CVD batch device which involves the heating of the semiconductor wafer to a temperature exceeding 700 °C for tens and hundreds of minutes. A single-piece CVD device typically involves a plasma process at a temperature in the range of 300 to 650 °C and a heating process at a temperature in the range of 500 to 800 °C which however lasts only a few minutes.

However, even when aluminum nitride is used for the ceramic heater, cleaning gas consisting of fluoride material which is used for removing a film deposited on the wall of the chamber during the film forming process causes aluminum fluoride to be formed on the surface of the ceramic heater. The aluminum fluoride tends to peel off in time and migrate to other parts of the surface of the ceramic heater causing corrosion in such parts. Such corrosion reduces the service life of the expensive ceramic heater.

The progress of corrosion can be slowed down to a certain extent by lowering the heater temperature during the cleaning process. For instance, a cleaning process is performed at 400 °C following a film forming process at 600 °C. However, in this case, it is necessary to gradually change the temperature between the two processes to avoid the ceramic heater from being damaged by thermal impacts. Consequently, the cleaning process requires a considerable amount of time, and this seriously reduces the production efficiency of the semiconductor fabrication device.

### BRIEF SUMMARY OF THE INVENTION

In view of such problems of the prior art, a primary object of the present invention is to provide a heater device which is adapted to protect the surface of the heater.

A second object of the present invention is to provide a heater device which is economical to maintain.

A third object of the present invention is to provide a heater device which is thermally efficient, and capable of uniformly heating the work.

According to the present invention, such objects can be accomplished by providing a heater device, comprising: a heater, typically consisting of a ceramic heater, defining a heating surface; and a detachable ceramic plate which is placed on said heating surface so as to substantially entirely cover said heating surface, and in turn defines a surface for supporting an object to be heated.

Thus, the surface of the ceramic heater is protected by the cover made of a ceramic plate, and the surface of the ceramic heater is prevented from being directly exposed to gases. Therefore, even when corrosion due to the cleaning gas occurs, it is limited to the cover, and the ceramic heater can be renewed simply by replacing the cover.

If an electrode for radio frequency power is buried in the ceramic heater, and the ceramic plate has a thickness of no more than 2 mm, or if an electrode for radio frequency power is buried in the ceramic plate, and the ceramic plate has a thickness of no more than 5 mm, the uniformity of the surface temperature of the ceramic plate supporting the object to be heated can be adequately ensured, and plasma can be generated without involving any substantial loss in the radio frequency power.

If the ceramic plate is made of ceramic material essentially consisting of aluminum nitride or magnesia, not only a favorable uniformity of the surface temperature can be achieved because of the favorable thermal conductivity of such materials, but also the service life of the ceramic plate can be increased because of the high corrosion resistance of such materials.

The ceramic plate may further comprise any surface features such as an annular low wall surrounding said supporting surface or a hole for receiving a lifting pin. Thus, the heater device can be readily adapted for different applications by using a same heater and different cover plates. This increases the versatility of the heater device, and contributes to the reduction in the overall cost.

The present invention also provides a film forming device, comprising: a process vessel defining a process chamber; a heater defining a heating surface and placed in said process chamber; and a ceramic plate which is detachably placed on said heating surface of said heater so as to substantially entirely cover said heating surface and defining a surface for supporting an object of a film forming process.

Thus, the heating surface of the heater, typically consisting of a ceramic heater, placed in a film forming chamber for normally supporting and heating an object of a film forming process can be protected by the cover made of a ceramic plate, and the surface of the ceramic heater is prevented from being directly exposed to the cleaning gas. Because the corrosion caused by the cleaning gas is limited to the cover, the ceramic heater can be renewed simply by replacing the cover. This substantially facilitates the maintenance work of the film forming device, and reduces the running cost.

### BRIEF DESCRIPTION OF THE DRAWINGS

Now the present invention is described in the following with reference to the appended drawings, in which:
Figure 1 is a schematic vertical sectional view of a ceramic heater device for use in plasma CVD embodying the present invention;
Figure 2 is a view similar to Figure 1 showing a second embodiment of the present invention;
Figure 3 is a view similar to Figure 1 showing a third embodiment of the present invention; and
Figure 4 is a schematic sectional side view generally showing a film forming device embodying the present invention.

### DETAILED DESCRIPTION OF THE PREFERRED EMBODIMENTS

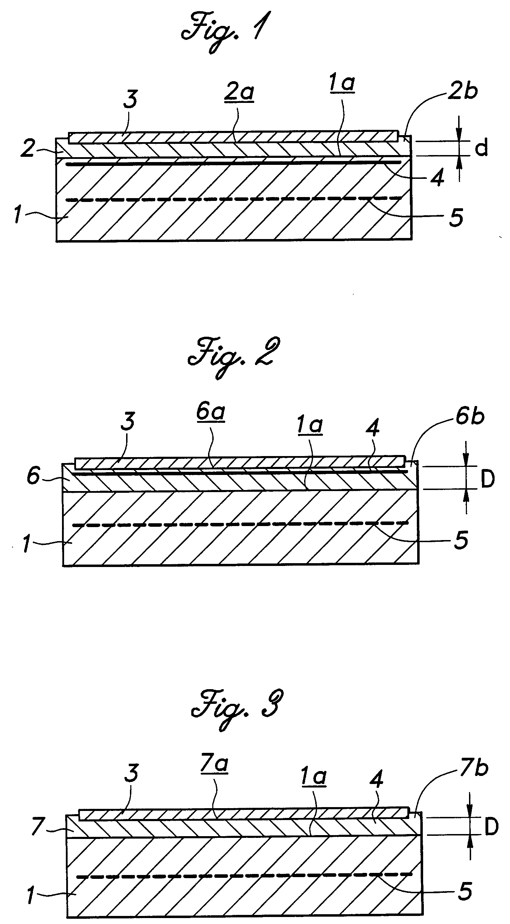

Figure 1 is a schematic vertical sectional view of a ceramic heater device for a CVD device embodying the present invention. This device comprises a disk-shaped lower ceramic heater 1 and a cover plate 2 placed on the ceramic heater 1 so as to cover the entire surface thereof (upper surface in the drawing). The upper surface of the cover plate 2 as seen in the drawing supports an object to be heated such as a silicon wafer 3.

The ceramic heater 1 may be made of alumina, but may also be made of a ceramic material essentially consisting of aluminum nitride or magnesia. Electrodes 4 for radio frequency power are buried in an upper part of the ceramic heater 1, and a heater wire 5 is buried in the ceramic heater 1 in a vertically intermediate part thereof. The electrode 4 for radio frequency power and the heater wire 5 are connected to a high frequency power source and an AC power source, respectively, or grounded as required.

The cover plate 2 may also be made of alumina, but is more preferably made of ceramic material essentially consisting of aluminum nitride or magnesia having a higher thermal conductivity and a higher corrosion resistance. The surface of the cover plate 2 has a recessed flat surface 2a for supporting the bottom surface of the silicon wafer 3 and a low annular wall 2b provided around the periphery of the flat surface 2a so as to receive a lower half of the peripheral part of the silicon wafer 3. The surface of the cover plate 2 is provided with various features including a hole for receiving a lift pin not shown in the drawing. The cover plate 2 is placed on the surface 1a of the ceramic heater 1.

In this ceramic heater device, the electrodes 4 for radio frequency power are desired to be as close to the wafer supporting surface 2a of the cover plate 2 as possible in view of the power efficiency. Therefore, the electrodes 4 are provided in a relatively upper part of the ceramic heater 1, and the cover plate 2 is provided with a relatively small thickness . On the other hand, the cover plate 2 is required to have a certain thickness for the convenience of handling, and is desired to have as great a thickness as possible in view of equalizing the temperature. However, the equalization of the temperature may be accomplished by suitable arrangement of the heating element. Based on such considerations, the thickness d of the cover plate 2 is preferred to be 2 mm or less, and the lower limit should be determined by the convenience of handling.

Because the cover plate 2 is placed on the surface of the ceramic heater 1, the surface of the ceramic heater 1 is prevented from being directly exposed, and is therefore protected from the cleaning gas. Therefore, the corrosion due to the cleaning gas is limited to the cover plate 2, and the ceramic heater 1 can be renewed simply by replacing the cover plate 2. This minimizes the time and cost required for the maintenance work.

Furthermore, the ceramic heater 1 needs to be provided only with a flat heating surface 1a, and this allows the heater 1 to be used in a wide range of applications. Various surface features, such as a hole for a lifting pin, a recessed surface for receiving a silicon wafer and so on may be provided in the cover plate 2. Therefore, the particular heater device can be adapted to each specific need simply by changing the cover plate 2 which is substantially less expensive than the ceramic heater 1. This contributes to a substantial reduction in the overall equipment cost.

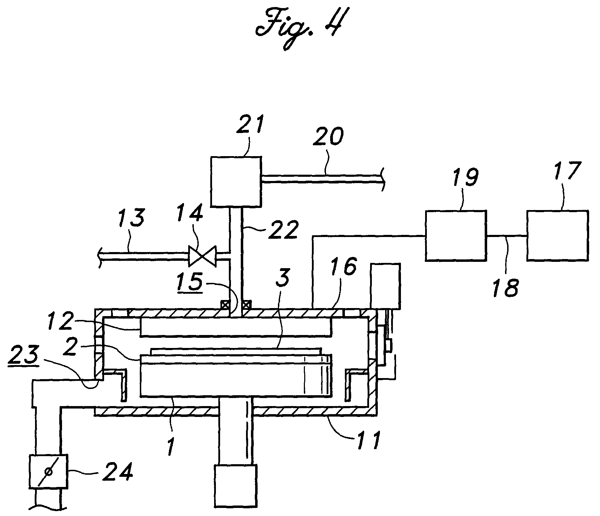

The present invention is not limited to the foregoing illustrated embodiment, and a second embodiment of the present invention is shown in Figure 2. The parts corresponding to those of the previous embodiment are denoted with like numerals without repeating the description of such parts.

Referring to Figure 2, a cover plate 6 is placed on the surface 1a of the ceramic heater 1, and a silicon wafer 3 is placed on a recessed supporting surface 6a of the cover plate 6. The outer periphery of the supporting surface 6a is provided with a low annular wall 6b so as to receive a lower half of the peripheral part of the silicon wafer 3. So far, this embodiment is not different from the previous embodiment. In this embodiment, however, electrodes 4 for radio frequency power are placed in an upper part of the cover plate 6 as seen in the drawing, instead of the ceramic heater 1.

This embodiment provides similar advantages as the previous embodiment. In this case, because the electrodes 4 for radio frequency power are provided in the cover plate 6, the thickness of the cover plate 6 may be increased without increasing the distance between the electrodes 4 and the silicon wafer 3. Therefore, to ensure both the uniformity of the temperature of the supporting surface 6a and the heating efficiency of the ceramic heater to be satisfactory, the thickness D of the cover plate 6 is preferred to be 5 mm or less.

Figure 3 shows a ceramic heater device for a single-piece low pressure thermal CVD device embodying the present invention. The parts corresponding to those of the previous embodiment are denoted with like numerals without repeating the description of such parts. The embodiment illustrated in Figure 3 is not provided with any electrodes for radio frequency power, as opposed to the embodiment illustrated in Figures 1 and 2, and is therefore suited for use in a film forming process not using any radio frequency power. In this case, based on the considerations for the heating efficiency of the ceramic heater 1 and the uniformity of the temperature of the supporting surface 7a, the thickness D of the cover plate 7 is preferred to be 5 mm or less. In this case, due the absence of the electrodes for radio frequency power, the ceramic heater itself may consist of any conventional heater which may also be metallic as well as ceramic.

The cover plates 2, 6 and 7 in the foregoing embodiments are each adapted to be simply placed on the surface 1a of the ceramic heater 1, and are therefore easy to replace. Thus, when the surface of the cover plate 2, 6 or 7 has worn due to corrosion, it can be readily replaced. By suitably determining the thickness of the cover plate 2, 6 or 7, the uniformity of the surface temperature can be ensured.

An exemplary film forming device using a ceramic heater 1 according to the present invention is described in the following with reference to Figure 4. This film forming device is adapted for the plasma CVD process in which the heater temperature is selected from the range of 300 to 650 °C and radio frequency power is used, and the thermal CVD process in which the heater temperature is selected from the range of 500 to 800 °C and a thermal reaction is utilized. When cleaning the vessel after such a CVD process, the remote plasma cleaning is performed.

A resistive ceramic heater 1 is placed in a process vessel 11 defining a plasma process chamber therein, and an object to be processed such as a semiconductor silicon wafer 3 is placed on a cover plate 2 which is heated by the ceramic heater 1. A showerhead 12 for supplying reaction gases evenly to the silicon wafer 3 is provided above the silicon wafer 3 as seen in the drawing. The reaction gases for forming a film on the surface of the silicon wafer 3 are metered by a mass flow controller (not shown in the drawing), and are conducted through an introduction pipe 13. The reaction gases are then forwarded to the showerhead 12 via a valve 14 and an upper opening 15 of the process vessel 11.

An output cable 18 of a radio frequency oscillator 17 is connected to the upper wall 16 of the process vessel 11 via a matching circuit 19 to supply the radio frequency power for use in the plasma CVD process.

The cleaning gas (typically containing fluoride gas such as C₂F₆+O₂ and NF₃+Ar) for removing depositions in the process vessel 11 is metered as prescribed, and is introduced into a remote plasma discharge device 21 via a pipe 20. The cleaning gas which is energized by the remote plasma discharge device 21 is introduced into the aforementioned opening 15 of the process vessel 11 via a pipe 22. The energized cleaning gas which is introduced into the process vessel 11 from the opening 15 is evenly introduced into the process vessel 11 via the showerhead 12. An opening 23 is formed in a lower part of the process vessel 11 as seen in the drawing, and is connected to an external vacuum pump (not shown in the drawing) via a conductance regulating valve 24 provided in an intermediate part of a pipe.

The process of forming a functional thin film in the CVD device using the ceramic heater 1 according to the present invention is described in the following.

The surface of the cover plate 2 (which may also consist of the cover plate 6 described earlier) is heated to a same temperature as the processing temperature (300 to 650 °C) by heating a resistive heating element (which may consist of the heater wire 5 described earlier). The silicon wafer 3 is transported into the process vessel 11 by an automatic conveying robot (not shown in the drawing) before starting the film forming process.

The reaction gases (such as SiH₄, NH₃, N₂, Ar and so forth) are introduced from the pipe 13 to the pipe 22 via the valve 14, and are evenly distributed into the process vessel 11 via the opening 15 and showerhead 12. The pressure in the process vessel 11 is controlled in the range of 0.5 torr to 10 torr by adjusting the opening of the conductance regulating valve 24 while introducing the reaction gases at a prescribed flow rate ratio.

Thus, while controlling the reaction temperature, reaction gas flow rates and reaction pressure to prescribed values, prescribed radio frequency power is applied across the electrodes to generate plasma and form a desired functional film on the surface of the silicon wafer 3. Upon completion of the film forming process, the supply of reaction gases and radio frequency power is terminated and the interior of the process vessel 11 is evacuated by using a vacuum pump (not shown in the drawing). The silicon wafer 3 is then conveyed out of the process vessel 11 by using an automatic conveying robot (not shown in the drawing) before the film forming process is completed.

After the film forming process for one to several tens of silicon wafers is completed, the depositions which may be attached to the surface of the cover plate 2 and the inner wall of the process vessel 11 are removed according to a prescribed cleaning sequence. The cleaning of the inner wall surface of the process vessel may be based on the in-situ cleaning process which makes use of the radio frequency power source and radio frequency electrodes that are used for the film forming process for the silicon wafer 3. This sequence is similar to that for the film forming process except for the energization process for the cleaning gas.

An exemplary plasma silicon nitride (P-SiN) film formed by using the film forming device of the present invention is described in the following with reference to Figure 4.

The condition for forming a plasma silicon nitride (P-SiN) film according to the conventional method without using a cover plate, along with the measured film quality, is shown in the following.

The flow rate of SiH₄ was 30 (sccm), the flow rate of N₂ was 5,000 (sccm), the heater temperature was 600 °C, the pressure was 4.25 torr, the radio frequency power was 400 W, and the distance between the electrodes was 14 mm. No cover plate was used. The obtained film had a refractive index of 1.972, the film forming speed was 101 nm/min, and the hydrogen concentration within the film was 6.9%.

A plasma silicon nitride film was formed on a silicon wafer according to the present invention. The silicon wafer 3 was placed on a cover plate 2 having a thickness of 1 mm which is in turn placed on the ceramic heater 1.

The flow rate of SiH₄ was 30 (sccm), the flow rate of N₂ was 5,000 (sccm), the heater temperature was 645 °C, the pressure was 4.25 torr, the radio frequency power was 420 W, the distance between the electrodes was 14 mm, and the thickness of the cover plate was 1 mm. The obtained film had a refractive index of 1.971, the film forming speed was 102 nm/min, and the hydrogen concentration within the film was 6.7%.

Thus, there was no substantial difference in the quality (such as the refractive index, film forming speed, and hydrogen concentration within the film) of the P-SiN film between the conventional process and the present invention. By noting that the thickness of the cover plate 3 was 1 mm according to this embodiment, the heater temperature was set 45 °C higher and the radio frequency power was increased by 20 W as compared with the conventional example. It was found that the desired P-SiN film can be obtained without any problem simply by taking such measures.

Thus, according to the present invention, because the corrosion due to the cleaning gas occurs only to the cover consisting of a ceramic cover plate, the ceramic heater can be renewed simply by replacing the cover. Therefore, the cost of the maintenance work can be substantially reduced. If high frequency electrodes are buried in the ceramic heater, and the thickness of the ceramic cover plate is no more than 2 mm or if high frequency electrodes are buried in the ceramic cover plate, and the thickness of the ceramic cover plate is no more than 5 mm, the uniformity of the surface temperature of the cover plate can be adequately ensured. If the cover plate is made of ceramic material essentially consisting of aluminum nitride or magnesia, a uniformity in the surface temperature can be ensured owing to the favorable thermal conductivity of the material. Because of the high corrosion resistance of the material, the frequency of replacing the cover plate can be reduced, and this contributes to the reduction in the cost of the maintenance work.

Although the present invention has been described in terms of preferred embodiments thereof, it is obvious to a person skilled in the art that various alterations and modifications are possible without departing from the scope of the present invention which is set forth in the appended claims.

## Claims

1. A heater device, comprising:
a heater defining a heating surface; and
a detachable ceramic plate which is placed on said heating surface so as to substantially entirely cover said heating surface, and in turn defines a surface for supporting an object to be heated.

2. A heater device according to claim 1, wherein said heater consists of a ceramic heater.

3. A heater device according to claim 2, wherein an electrode for radio frequency power is buried in said ceramic heater.

4. A heater device according to claim 3, wherein said ceramic plate has a thickness of no more than 2 mm.

5. A heater device according to claim 1, wherein an electrode for radio frequency power is buried in said ceramic plate.

6. A heater device according to claim 5, wherein said ceramic plate has a thickness of no more than 5 mm.

7. A heater device according to claim 1, wherein said ceramic plate is made of ceramic material essentially consisting of aluminum nitride or magnesia.

8. A heater device according to claim 1, wherein said ceramic plate further comprises an annular low wall surrounding said supporting surface.

9. A film forming device, comprising:
a process vessel defining a process chamber;
a heater defining a heating surface and placed in said process chamber; and
a ceramic plate which is detachably placed on said heating surface of said heater so as to substantially entirely cover said heating surface and defining a surface for supporting an object of a film forming process.
